# EUROPÄISCHE PATENTANMELDUNG

(11) **EP 4 351 291 A1**
(43) Veröffentlichungstag der Anmeldung: **10.04.2024**
(21) Anmeldenummer: 23198666.2
(22) Anmeldetag: 20.09.2023
(51) Int. Cl.: H05K 7/14

(54) **KOMPONENTENANORDNUNG FÜR EINE LEISTUNGSELEKTRONIK UND VERFAHREN ZUM BEREITSTELLEN EINER KOMPONENTENANORDNUNG FÜR EINE LEISTUNGSELEKTRONIK**

(30) Priorität: 07.10.2022 DE 102022210631
(71) Anmelder: Volkswagen Aktiengesellschaft, 38440 Wolfsburg (DE)
(72) Erfinder: Arnaout, Samy, 34305 Niedenstein (DE); Schmäling, Jan, 34225 Baunatal (DE); Rang, Oliver, 34132 Kassel (DE)

(57) **Zusammenfassung**

Die Erfindung betrifft eine Komponentenanordnung (1) für eine Leistungselektronik, umfassend mindestens ein Leistungsmodul (2), mindestens ein hiervon separates Verbindungsmodul (3), einen hiervon separaten Steuerschaltungsträger (4), und ein Gehäuse (5), wobei das mindestens eine Leistungsmodul (2), das mindestens eine Verbindungsmodul (3) und der hiervon separate Steuerschaltungsträger (4) in vorgegebener Weise in dem Gehäuse (5) angeordnet sind, wobei das mindestens eine Leistungsmodul (2) mittels erster elektrischer Signalleitungen (6) mit dem mindestens einen Verbindungsmodul (3) verbunden ist, und wobei das mindestens eine Verbindungsmodul (3) mittels zweiter elektrischer Signalleitungen (7) mit dem Steuerschaltungsträger (4) verbunden ist.

## Beschreibung

Die Erfindung betrifft eine Komponentenanordnung für eine Leistungselektronik und ein Verfahren zum Bereitstellen einer Komponentenanordnung für eine Leistungselektronik.

In der Leistungselektronik werden Leistungsmodule eingesetzt. Derzeit werden diese direkt mit Hilfe von Press-Fit-Pins, Lötpins, Steckkontakten oder Schraubkontakten elektrisch mit einem Steuerschaltungsträger (Steuerplatine) verbunden und insbesondere auf diesen aufgesteckt. In Pulswechselrichtern werden Leistungsmodule in der Regel über Press-Fit-Pins verbunden.

In einer Entwicklungsphase der Leistungsmodule müssen bereits zu einem sehr frühen Zeitpunkt Schnittstellen der Leistungsmodule zum Steuerschaltungsträger festgelegt werden, da die Leistungsmodule in der Regel lange Werkzeugerstell- und Freigabezeiten haben, welche die Entwicklungszeit von Pulswechselrichtern dominieren. Hierdurch gibt das Leistungsmodul zu einem frühen Entwicklungszeitpunkt bereits eine Bauraumaufteilung und ein Design der Leistungselektronik, insbesondere des Pulswechselrichters, vor und schränkt eine Flexibilität ein.

Der Erfindung liegt die Aufgabe zu Grunde, eine Lösung für das vorgenannte Problem anzugeben, wobei mit der Lösung insbesondere eine größere Flexibilität während der Entwicklungsphase der Leistungselektronik erreicht werden soll.

Die Aufgabe wird erfindungsgemäß durch eine Komponentenanordnung mit den Merkmalen des Patentanspruchs 1 und ein Verfahren mit den Merkmalen des Patentanspruchs 10 gelöst. Vorteilhafte Ausgestaltungen der Erfindung ergeben sich aus den Unteransprüchen.

Insbesondere wird eine Komponentenanordnung für eine Leistungselektronik geschaffen, umfassend mindestens ein Leistungsmodul, mindestens ein hiervon separates Verbindungsmodul, einen hiervon separaten Steuerschaltungsträger, und ein Gehäuse, wobei das mindestens eine Leistungsmodul, das mindestens eine Verbindungsmodul und der hiervon separate Steuerschaltungsträger in vorgegebener Weise (d.h. insbesondere an vorgegebenen räumlichen Positionen) in dem Gehäuse angeordnet sind, wobei das mindestens eine Leistungsmodul mittels erster elektrischer Signalleitungen mit dem mindestens einen Verbindungsmodul verbunden ist, und wobei das mindestens eine Verbindungsmodul mittels zweiter elektrischer Signalleitungen mit dem Steuerschaltungsträger verbunden ist.

Ferner wird insbesondere ein Verfahren zum Bereitstellen einer Komponentenanordnung für eine Leistungselektronik zur Verfügung gestellt, wobei mindestens ein Leistungsmodul, mindestens ein hiervon separates Verbindungsmodul, und ein hiervon separater Steuerschaltungsträger in vorgegebener Weise und vorgegebener Reihenfolge in einem Gehäuse angeordnet und elektrisch miteinander verbunden werden, wobei hierzu das mindestens eine Leistungsmodul mittels erster elektrischer Signalleitungen mit dem mindestens einen Verbindungsmodul verbunden wird und das mindestens eine Verbindungsmodul mittels zweiter elektrischer Signalleitungen mit dem Steuerschaltungsträger verbunden wird.

Die Komponentenanordnung und das Verfahren ermöglichen es, Ausgestaltungen von elektrischen Schnittstellen und/oder Anbindungen eines Leistungsmoduls und eines Steuerschaltungsträgers (welcher auch als Steuerplatine bezeichnet werden kann) im Entwicklungsprozess voneinander zu entkoppeln. Hierzu wird ein von dem Leistungsmodul und dem Steuerschaltungsträger (mechanisch) separates Verbindungsmodul geschaffen, über das die elektrischen Verbindungen jeweils ausgebildet werden. Insbesondere ist vorgesehen, dass elektrische Verbindungen zwischen dem mindestens einen Leistungsmodul und dem Steuerschaltungsträger ausschließlich über das mindestens eine Verbindungsmodul ausgebildet werden. Insbesondere ist bzw. wird das mindestens eine Leistungsmodul elektrisch nicht direkt mit dem Steuerschaltungsträger verbunden. Die elektrischen Verbindungen werden mittels jeweiliger Signalleitungen ausgebildet. Die Module und der Steuerschaltungsträger sind in vorgegebener Weise in dem Gehäuse angeordnet. Die vorgegebene Weise betrifft hierbei insbesondere eine zweidimensionale und/oder dreidimensionale Position innerhalb des Gehäuses und/oder eine relative Anordnung der Module und/oder des Steuerschaltungsträgers zueinander. Die Module und der Steuerschaltungsträger sind insbesondere jeweils voneinander unabhängige Komponenten, welche insbesondere auf verschiedenen räumlichen Positionen angeordnet sind.

Ein Vorteil der Komponentenanordnung und des Verfahrens ist, dass der Entwicklungsprozess insbesondere des Leistungsmoduls hierdurch flexibler ausgestaltet werden kann, da eine Schnittstelle auch zu einem späteren Zeitpunkt durch ein weniger aufwändiges Anpassen des verwendeten Verbindungsmoduls erfolgen kann. Hierdurch können Zeit und Aufwand gespart und Flexibilität gewonnen werden. Ferner kann eine elektrische Verbindung zwischen den Leistungsmodulen und dem Steuerschaltungsträger im Hinblick auf eine Verschaltung und/oder eine räumliche Anordnung flexibler ausgestaltet werden. Vermittelt durch das mindestens eine Verbindungsmodul kann eine elektrische Verbindung insbesondere auch über mehrere Ebenen ausgebildet werden und/oder das Verbindungsmodul kann zwei Ebenen elektrisch miteinander verbinden.

Die Module und die Schaltungsträgerlage sind insbesondere einzelne, das heißt voneinander separate, Komponenten. Die Module und die Schaltungsträgerlage sind insbesondere untereinander nicht (direkt) miteinander in mechanischem Kontakt.

Ein Leistungsmodul ist insbesondere eine Leistungskomponente eines Stromrichters, insbesondere eines Pulswechselrichters. Insbesondere umfasst das Leistungsmodul eine Halbbrückenschaltung, welche insbesondere auf einem keramischen Substrat aufgebracht ist und insbesondere gemoldet ist. Insbesondere kann die Komponentenanordnung mehrere solcher Leistungsmodule, insbesondere drei solcher Leistungsmodule, umfassen. Diese mehreren Leistungsmodule können beispielsweise auf einem (gemeinsamen) Kühlkörper angeordnet sein oder angeordnet werden.

Ein Steuerschaltungsträger ist insbesondere eine Steuerplatine, insbesondere für einen Stromrichter, insbesondere einen Pulswechselrichter. Der Steuerschaltungsträger umfasst insbesondere Bauteile zur Steuerung und Überwachung des mindestens einen Leistungsmoduls und/oder des Stromrichters, insbesondere des Pulswechselrichters. Der Steuerschaltungsträger kann beispielsweise mindestens eine der folgenden Komponenten umfassen: Mikrocontroller, Gatetreiber, ASIC und/oder eine Kommunikationsschnittstelle (z.B. CAN).

Das Verbindungsmodul kann insbesondere neben (reinen) elektrischen Verbindungen weitere aktive und/oder passive elektrische Bauelemente umfassen. Es kann insbesondere vorgesehen sein, dass über ein einziges Verbindungsmodul mit den Signalleitungen elektrische Verbindungen zu mehreren Leistungsmodulen und dem Steuerschaltungsträger ausgebildet sind oder ausgebildet werden. Das Verbindungsmodul weist insbesondere Abmessungen im Zentimeterbereich, insbesondere im Bereich von einigen wenigen Zentimetern auf, beispielsweise mit einer Breite im Bereich von 2 bis 5 cm und einer Länge im Bereich von 8 bis 15 cm, beispielsweise 3×9 cm² oder 3×15 cm².

Die elektrischen Signalleitungen sind bei einem Gatepfad insbesondere für eine Stromstärke im Bereich bis 1 A, insbesondere bis 10 A, weiter insbesondere bis 20 A ausgelegt. Bei einem Source- oder Drainpfad sind die elektrischen Signalleitungen insbesondere für eine Stromstärke im Bereich von µA bis mA ausgelegt.

Ein Leistungsmodul weist insbesondere Abmessungen im Zentimeterbereich, insbesondere im Bereich von einigen wenigen Zentimetern auf, beispielsweise mit Seitenlängen einer Breite und Länge von jeweils zwischen 3 cm bis 15 cm, beispielsweise 5×4 cm². Je nach Strombedarf können die Werte grundsätzlich aber auch kleiner oder größer sein.

Ein Verbindungsbereich (welcher insbesondere auch als Verbindungspad bezeichnet werden kann), an dem die elektrischen Signalleitungen mit den Modulen oder dem Steuerschaltungsträger verbunden sind oder verbunden werden, weist insbesondere eine Seitenlänge im Bereich von 0,2 bis 0,5 cm auf.

In einer Ausführungsform ist vorgesehen, dass das mindestens eine Verbindungsmodul ein vorgegebenes elektrisches Leitungslayout aufweist, welches Verbindungsbereiche der ersten elektrischen Signalleitungen in vorgegebener Weise (d.h. insbesondere gemäß einem vorgegebenen Schaltplan) elektrisch mit Verbindungsbereichen der zweiten elektrischen Signalleitungen verbindet. Hierdurch kann eine vorgegebene Zuordnung der ersten elektrischen Signalleitungen zu den zweiten elektrischen Signalleitungen erfolgen. Insbesondere kann diese Zuordnung im Rahmen des Entwicklungsprozesses flexibel gewählt und/oder auch zu einem späteren Zeitpunkt noch angepasst werden, was vorteilhaft für den Entwicklungsprozess ist. Das elektrische Leitungslayout kann insbesondere elektrische Leiterbahnen, beispielsweise in Form von gestanzten Blechen, umfassen.

In einer Ausführungsform ist vorgesehen, dass zumindest eine Anzahl der Verbindungsbereiche, an denen die elektrischen Signalleitungen jeweils mit den Modulen und/oder dem Steuerschaltungsträger verbunden sind, zumindest teilweise mit einer Moldmasse umgeben ist. Hierdurch können Kontaktstellen, an denen die elektrischen Verbindungen jeweils ausgebildet sind, verbessert geschützt werden, um ein Risiko für ein Abreißen und/oder eine Beschädigung der elektrischen Verbindungen zu verringern. Die Moldmasse ist insbesondere elektrisch nicht leitend. Die Moldmasse ist oder umfasst beispielsweise ein Epoxidharz.

Es kann auch vorgesehen sein, dass ein Bereich, an dem die elektrischen Signalleitungen jeweils mit den Modulen und/oder dem Steuerschaltungsträger verbunden sind, vollständig über alle Signalleitungen hinweg mit einer Moldmasse umgeben ist. Ferner kann auch vorgesehen sein, einen Flächenbereich des mindestens einen Verbindungsmoduls und/oder des mindestens einen Leistungsmoduls und/oder des Steuerschaltungsträgers vollständig mit der Moldmasse zu bedecken. Insbesondere kann eine Oberfläche des Verbindungsmoduls vollflächig mit einer Moldmasse bedeckt sein.

Weiter kann vorgesehen sein, dass die Module und/oder der Steuerschaltungsträger mittels der Moldmasse mechanisch, insbesondere an dem Gehäuse, fixiert sind oder fixiert werden.

In einer Ausführungsform ist vorgesehen, dass das mindestens eine Leistungsmodul und/oder das mindestens eine Verbindungsmodul und/oder der Steuerschaltungsträger mit Bezug auf eine Ebene des Steuerschaltungsträgers in unterschiedlichen Ebenen angeordnet sind. Hierdurch kann einerseits Bauraum eingespart werden, da die Komponenten in unterschiedlichen Ebenen, insbesondere zumindest teilweise auch übereinander, angeordnet sein können. Andererseits können hierdurch auch eine Anordnung und ein Herstellungsprozess flexibler ausgestaltet werden. So können die elektrischen Verbindungen mit Bezug auf die jeweiligen Verbindungsbereiche an ihren jeweiligen Enden auf unterschiedlichen Ebenen ausgebildet sein. Das Verbindungsmodul erlaubt in vorteilhafter Weise insbesondere das Überbrücken von unterschiedlichen Ebenen.

In einer Ausführungsform ist vorgesehen, dass das mindestens eine Leistungsmodul, das mindestens eine Verbindungsmodul und der Steuerschaltungsträger mechanisch mit dem Gehäuse verbunden sind. Hierdurch können die Komponenten jeweils fest mit dem Gehäuse verbunden sein oder verbunden werden. Eine mechanische Verbindung zum Gehäuse kann auch eine mechanische Verbindung zu einem Kühlkörper des Gehäuses sein. Insbesondere kann das Leistungsmodul mit einem Kühlkörper des Gehäuses mechanisch verbunden sein.

In einer weiterbildenden Ausführungsform ist vorgesehen, dass das mindestens eine Leistungsmodul, das mindestens eine Verbindungsmodul und der Steuerschaltungsträger mechanisch jeweils separat mit dem Gehäuse verbunden sind. Hierdurch können die einzelnen mechanischen Verbindungen zum Gehäuse jeweils angepasst auf die jeweilige Komponente gewählt werden. Hierdurch kann eine Flexibilität im Entwicklungsprozess weiter erhöht werden.

In einer weiteren Ausführungsform ist vorgesehen, dass das mindestens eine Leistungsmodul zumindest teilweise zwischen dem Steuerschaltungsträger und dem Gehäuse angeordnet ist, wobei das mindestens eine Verbindungsmodul mit Bezug auf eine Ausdehnungsrichtung einer Ebene des Steuerschaltungsträgers neben dem Steuerschaltungsträger angeordnet ist. Hierdurch kann insbesondere Bauraum eingespart werden. Darüber hinaus kann die Anordnung im Gehäuse flexibler erfolgen, da aus einer größeren Anzahl von Möglichkeiten der Anordnung gewählt werden kann. Im Verfahren zum Bereitstellen der Komponentenanordnung ist dann insbesondere vorgesehen, dass zuerst das mindestens eine Leistungsmodul und das mindestens eine Verbindungsmodul angeordnet werden, und dann (zumindest teilweise darüber) der Steuerschaltungsträger. Zuerst werden auch die ersten elektrischen Signalleitungen zwischen dem mindestens einen Leistungsmodul und dem mindestens einen Verbindungsmodul ausgebildet, insbesondere wenn diese Komponenten bereits im Gehäuse angeordnet sind. Nach dem Anordnen des Steuerschaltungsträgers im Gehäuse werden dann die zweiten elektrischen Signalleitungen zwischen dem mindestens einen Verbindungsmodul und dem Steuerschaltungsträger ausgebildet.

In einer Ausführungsform ist vorgesehen, dass zumindest eine Anzahl der ersten elektrischen Signalleitungen und/oder der zweiten elektrischen Signalleitungen als Bondverbindungen ausgebildet ist. Die Bondverbindungen sind insbesondere als Dickdrahtbondverbindungen ausgebildet (Drahtstärke im Bereich von 125 µm). Die Bondverbindungen können insbesondere als Double Stitch-Bondverbindungen, Dickdrahtbondverbindungen, Aluminiumkupfer-Bondverbindungen, Aluminium-Bondverbindungen und/oder Aluminiumgold-Bondverbindungen ausgebildet sein.

In einer Ausführungsform ist vorgesehen, dass zumindest eine Anzahl der ersten elektrischen Signalleitungen und/oder der zweiten elektrischen Signalleitungen in Form von elektrisch leitenden Blechen ausgebildet ist. Die Bleche können insbesondere gestanzt sein. Die Bleche können insbesondere durch zusätzliche Elemente mechanisch verstärkt sein, beispielsweise durch elektrisch nicht-leitende Trägerelemente. Auf diese Weise können insbesondere fingerartige Verbindungen ausgebildet werden, die die elektrischen Signalleitungen ausbilden.

Ferner wird insbesondere auch ein Fahrzeug geschaffen, umfassend mindestens eine Komponentenanordnung nach einer der beschriebenen Ausführungsformen. Ein Fahrzeug ist insbesondere ein Kraftfahrzeug. Grundsätzlich kann das Fahrzeug aber auch ein anderes Land-, Schienen-, Wasser-, Luft- oder Raumfahrzeug sein, beispielsweise ein Lufttaxi oder eine Drohne.

Weitere Merkmale zur Ausgestaltung des Verfahrens ergeben sich aus der Beschreibung von Ausgestaltungen der Komponentenanordnung. Die Vorteile des Verfahrens sind hierbei jeweils die gleichen wie bei den Ausgestaltungen der Komponentenanordnung.

Nachfolgend wird die Erfindung anhand bevorzugter Ausführungsbeispiele unter Bezugnahme auf die Figuren näher erläutert. Hierbei zeigen:
- Fig. 1: eine schematische Darstellung von Ausführungsformen der Komponentenanordnung für eine Leistungselektronik in einer Seitenansicht;
- Fig. 2: eine schematische Darstellung von Ausführungsformen der Komponentenanordnung für eine Leistungselektronik in einer Draufsicht;
- Fig. 3: ein schematisches Ablaufdiagramm einer Ausführungsform des Verfahrens.

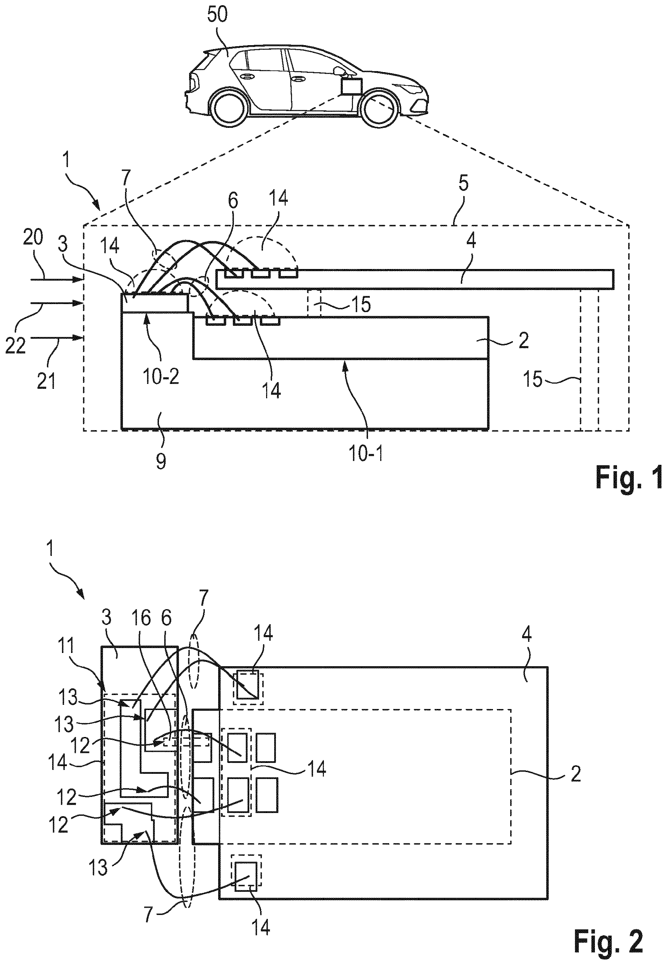

Die Fig. 1 zeigt eine schematische Darstellung von Ausführungsformen der Komponentenanordnung 1 für eine Leistungselektronik als Seitenansicht. Die Komponentenanordnung 1 ist beispielsweise in einem Fahrzeug 50, insbesondere einem Kraftfahrzeug, angeordnet. Die Komponentenanordnung 1 ist beispielsweise Teil einer Leistungselektronik eines Pulswechselrichters.

Die Komponentenanordnung 1 umfasst ein Leistungsmodul 2, ein hiervon separates Verbindungsmodul 3, einen hiervon separaten Steuerschaltungsträger 4 und ein Gehäuse 5. Grundsätzlich können weitere Leistungsmodule 2 und Verbindungsmodule 3 vorgesehen sein. Das Gehäuse 5 ist als geschlossenes Gehäuse dargestellt. Grundsätzlich kann das Gehäuse 5 aber auch an mindestens einer Seite eine Öffnung aufweisen. Das Leistungsmodul 2, das hiervon separate Verbindungsmodul 3 und der hiervon separate Steuerschaltungsträger 4 sind in vorgegebener Weise (d.h. insbesondere an vorgegebenen räumlichen Positionen) in dem Gehäuse 5 angeordnet. Das Leistungsmodul 2 ist mittels erster elektrischer Signalleitungen 6 mit dem Verbindungsmodul 3 verbunden. Das Verbindungsmodul 3 ist ferner mittels zweiter elektrischer Signalleitungen 7 mit dem Steuerschaltungsträger 4 verbunden. Die elektrischen Signalleitungen 6, 7 sind insbesondere als Bondverbindungen, insbesondere als Dickdrahtbondverbindungen, ausgebildet.

Es ist insbesondere vorgesehen, dass das Leistungsmodul 2 und das Verbindungsmodul 3 auf einem (insbesondere stufenförmigen) Kühlkörper 9 des Gehäuses 5 angeordnet sind. Hierbei ist insbesondere vorgesehen, dass der Kühlkörper 9 Stufen 10-1, 10-2 aufweist, wobei das Leistungsmodul 2 auf einer unteren Stufe 10-1 und das Verbindungsmodul 10-2 auf einer oberen Stufe 10-2 angeordnet ist. Sind weitere Module vorhanden, können weitere Stufen vorgesehen sein.

Es kann vorgesehen sein, dass das mindestens eine Verbindungsmodul 3 ein vorgegebenes elektrisches Leitungslayout 11 (Fig. 2) aufweist, welches Verbindungsbereiche 12 der ersten elektrischen Signalleitungen 6 in vorgegebener Weise elektrisch mit Verbindungsbereichen 13 der zweiten elektrischen Signalleitungen 7 verbindet. Diese Ausführungsform ist schematisch in der Fig. 2 verdeutlicht. Elektrische Verbindungen des Leitungslayouts 11 sind insbesondere als Leiterbahnen ausgebildet und die Verbindungsbereiche 12, 13 sind insbesondere als Bondpads ausgebildet.

Es kann vorgesehen sein, dass zumindest eine Anzahl der Verbindungsbereiche 12, 13, an denen die elektrischen Signalleitungen 6, 7 jeweils mit den Modulen 2, 3 und/oder dem Steuerschaltungsträger 4 verbunden sind, zumindest teilweise mit einer Moldmasse 14 umgeben ist. Die Moldmasse 14 kann beispielsweise ein Epoxidharz sein oder ein solches umfassen.

Es ist insbesondere vorgesehen, dass das Leistungsmodul 2 und/oder das Verbindungsmodul 3 und/oder der Steuerschaltungsträger 4 mit Bezug auf eine Ebene 20 des Steuerschaltungsträgers 4 in unterschiedlichen Ebenen 21, 22 angeordnet sind (Fig. 1).

Es kann vorgesehen sein, dass das Leistungsmodul 2, das Verbindungsmodul 3 und der Steuerschaltungsträger 4 mechanisch mit dem Gehäuse 5 verbunden sind. Bei dem Leistungsmodul 2 und dem Verbindungsmodul 3 erfolgt dies, wie bereits voranstehend beschrieben, insbesondere über den Kühlkörper 9. Der Steuerschaltungsträger 4 kann beispielsweise mittels zylinderförmigen Gewindeschrauben 15 an dem Gehäuse 5 angeordnet sein und von diesen insbesondere auf Abstand zum Gehäuse 5 gehalten werden.

Es ist insbesondere vorgesehen, dass das Leistungsmodul 2, das Verbindungsmodul 3 und der Steuerschaltungsträger 4 mechanisch jeweils separat mit dem Gehäuse 5 verbunden sind.

In den gezeigten Ausführungsformen ist insbesondere vorgesehen, dass das Leistungsmodul 2 zumindest teilweise zwischen dem Steuerschaltungsträger 4 und dem Gehäuse 5 angeordnet ist, wobei das Verbindungsmodul 3 mit Bezug auf eine Ausdehnungsrichtung einer Ebene 20 des Steuerschaltungsträgers 4 neben dem Steuerschaltungsträger 4 angeordnet ist. Dies ist deutlich in der Fig. 2 zu erkennen, in der das Verbindungsmodul 3 in einigem Abstand zum Steuerschaltungsträger 4 angeordnet ist.

Es ist insbesondere vorgesehen, dass zumindest eine Anzahl der ersten elektrischen Signalleitungen 6 und/oder der zweiten elektrischen Signalleitungen 7 als Bondverbindungen ausgebildet ist. Grundsätzlich können aber auch andere Verbindungsarten verwendet werden, zum Beispiel Press fit-Pins.

Es kann vorgesehen sein, dass zumindest eine Anzahl der ersten elektrischen Signalleitungen 6 und/oder der zweiten elektrischen Signalleitungen 7 in Form von elektrisch leitenden Blechen 16 (beispielhaft in Fig. 2 dargestellt) ausgebildet ist.

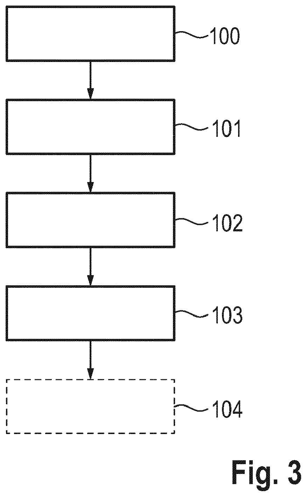

Die Fig. 3 zeigt ein schematisches Ablaufdiagramm einer Ausführungsform des Verfahrens zum Bereitstellen einer Komponentenanordnung für eine Leistungselektronik.

In einer Maßnahme 100 werden ein Leistungsmodul und ein Verbindungsmodul in einem Gehäuse, beispielsweise eines Pulswechselrichters, angeordnet. Beispielsweise werden das Leistungsmodul und das Verbindungsmodul hierzu nebeneinander auf einen Kühlkörper des Gehäuses angeordnet, beispielsweise auf unterschiedlichen Stufen des Kühlkörpers (vgl. Fig. 1). Hierzu werden die Module insbesondere mit dem Gehäuse mechanisch verbunden, beispielsweise mittels hierfür geeigneter zylinderförmiger Gewindeschrauben und/oder Abstandhalter aus Eisen und/oder Kunststoff und/oder durch sonstiges Fixieren am Kühlkörper. Das Fixieren kann beispielsweise auch mittels eines geeigneten Klebstoffs erfolgen.

In einer Maßnahme 101 werden das angeordnete Leistungsmodul und das angeordnete Verbindungsmodul elektrisch über erste Signalleitungen miteinander verbunden. Hierzu können beispielsweise Bondverbindungen und/oder Verbindungen aus leitenden Blechen ausgebildet werden.

In einer Maßnahme 102 wird ein von dem Leistungsmodul und dem Verbindungsmodul separater Steuerschaltungsträger in dem Gehäuse angeordnet. Hierzu wird der Steuerschaltungsträger insbesondere mit dem Gehäuse mechanisch verbunden, beispielsweise mittels hierfür geeigneter zylinderförmiger Gewindeschrauben und/oder Abstandhalter aus Eisen und/oder Kunststoff. Insbesondere wird der Steuerschaltungsträger hierbei derart in dem Gehäuse angeordnet, dass das Leistungsmodul zumindest teilweise zwischen dem Steuerschaltungsträger und dem Gehäuse angeordnet ist, wie dies beispielhaft in den Figuren 1 und 2 gezeigt ist.

In einer Maßnahme 103 wird das Verbindungsmodul mittels zweiter elektrischer Signalleitungen elektrisch mit dem Steuerschaltungsträger verbunden. Hierzu können beispielsweise Bondverbindungen und/oder Verbindungen aus leitenden Blechen ausgebildet werden.

Es kann in einer Maßnahme 104 vorgesehen sein, dass zumindest eine Anzahl von Verbindungsbereichen, an denen die elektrischen Signalleitungen jeweils mit den Modulen und/oder dem Steuerschaltungsträger verbunden sind, zumindest teilweise mit einer Moldmasse umgeben wird. Hierzu werden die Verbindungsbereiche mit der Moldmasse, beispielsweise mit einem Epoxidharz, umspritzt.

### Bezugszeichenliste

- 1: Komponentenanordnung
- 2: Leistungsmodul
- 3: Verbindungsmodul
- 4: Steuerschaltungsträger
- 5: Gehäuse
- 6: erste elektrische Signalleitung
- 7: zweite elektrische Signalleitung
- 9: Kühlkörper
- 10-x: Stufe
- 11: elektrische Leitungslayout
- 12: Verbindungsbereich
- 13: Verbindungsbereich
- 14: Moldmasse
- 15: Gewindeschraube
- 16: Blech
- 20: Ebene (Steuerschaltungsträger)
- 21: Ebene
- 22: Ebene
- 100-104: Maßnahmen

## Patentansprüche

1. Komponentenanordnung (1) für eine Leistungselektronik, umfassend:
mindestens ein Leistungsmodul (2),
mindestens ein hiervon separates Verbindungsmodul (3),
einen hiervon separaten Steuerschaltungsträger (4), und
ein Gehäuse (5),
wobei das mindestens eine Leistungsmodul (2), das mindestens eine Verbindungsmodul (3) und der hiervon separate Steuerschaltungsträger (4) in vorgegebener Weise in dem Gehäuse (5) angeordnet sind,
wobei das mindestens eine Leistungsmodul (2) mittels erster elektrischer Signalleitungen (6) mit dem mindestens einen Verbindungsmodul (3) verbunden ist, und
wobei das mindestens eine Verbindungsmodul (3) mittels zweiter elektrischer Signalleitungen (7) mit dem Steuerschaltungsträger (4) verbunden ist.

2. Komponentenanordnung (1) nach Anspruch 1, **dadurch gekennzeichnet, dass** das mindestens eine Verbindungsmodul (3) ein vorgegebenes elektrisches Leitungslayout (11) aufweist, welches Verbindungsbereiche (12) der ersten elektrischen Signalleitungen (6) in vorgegebener Weise elektrisch mit Verbindungsbereichen (13) der zweiten elektrischen Signalleitungen (7) verbindet.

3. Komponentenanordnung (1) nach Anspruch 1 oder 2, **dadurch gekennzeichnet, dass** zumindest eine Anzahl der Verbindungsbereiche (12,13), an denen die elektrischen Signalleitungen (6,7) jeweils mit den Modulen (2,3) und/oder dem Steuerschaltungsträger (4) verbunden sind, zumindest teilweise mit einer Moldmasse (14) umgeben ist.

4. Komponentenanordnung (1) nach einem der vorangegangenen Ansprüche, **dadurch gekennzeichnet, dass** das mindestens eine Leistungsmodul (2) und/oder das mindestens eine Verbindungsmodul (3) und/oder der Steuerschaltungsträger (4) mit Bezug auf eine Ebene (20) des Steuerschaltungsträgers (4) in unterschiedlichen Ebenen (21,22) angeordnet sind.

5. Komponentenanordnung (1) nach einem der vorangegangenen Ansprüche, **dadurch gekennzeichnet, dass** das mindestens eine Leistungsmodul (2), das mindestens eine Verbindungsmodul (3) und der Steuerschaltungsträger (4) mechanisch mit dem Gehäuse (5) verbunden sind.

6. Komponentenanordnung (1) nach einem der vorangegangenen Ansprüche, **dadurch gekennzeichnet, dass** das mindestens eine Leistungsmodul (2) zumindest teilweise zwischen dem Steuerschaltungsträger (4) und dem Gehäuse (5) angeordnet ist, wobei das mindestens eine Verbindungsmodul (3) mit Bezug auf eine Ausdehnungsrichtung einer Ebene (20) des Steuerschaltungsträgers (4) neben dem Steuerschaltungsträger (4) angeordnet ist.

7. Komponentenanordnung (1) nach einem der vorangegangenen Ansprüche, **dadurch gekennzeichnet, dass** zumindest eine Anzahl der ersten elektrischen Signalleitungen (6) und/oder der zweiten elektrischen Signalleitungen (7) als Bondverbindungen ausgebildet ist.

8. Komponentenanordnung (1) nach einem der vorangegangenen Ansprüche, **dadurch gekennzeichnet, dass** zumindest eine Anzahl der ersten elektrischen Signalleitungen (6) und/oder der zweiten elektrischen Signalleitungen (7) in Form von elektrisch leitenden Blechen (16) ausgebildet ist.

9. Fahrzeug (50), umfassend mindestens eine Komponentenanordnung (1) nach einem der Ansprüche 1 bis 8.

10. Verfahren zum Bereitstellen einer Komponentenanordnung (1) für eine Leistungselektronik,
wobei mindestens ein Leistungsmodul (2), mindestens ein hiervon separates Verbindungsmodul (3), und ein hiervon separater Steuerschaltungsträger (4) in vorgegebener Weise und vorgegebener Reihenfolge in einem Gehäuse (5) angeordnet und elektrisch miteinander verbunden werden,
wobei hierzu das mindestens eine Leistungsmodul (2) mittels erster elektrischer Signalleitungen (6) mit dem mindestens einen Verbindungsmodul (3) verbunden wird und das mindestens eine Verbindungsmodul (3) mittels zweiter elektrischer Signalleitungen (7) mit dem Steuerschaltungsträger (4) verbunden wird.
